(19) Europäisches Patentamt
European Patent Office
Office européen des brevets

(11) **EP 2 197 098 A1**

(12) **EUROPEAN PATENT APPLICATION**
published in accordance with Art. 153(4) EPC

(43) Date of publication:
16.06.2010 Bulletin 2010/24

(51) Int Cl.:
*H02N 11/00* *(2006.01)*

(21) Application number: 08833054.3

(22) Date of filing: 24.09.2008

(86) International application number:
PCT/JP2008/002627

(87) International publication number:
WO 2009/041020 (02.04.2009 Gazette 2009/14)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 27.09.2007 JP 2007250576

(71) Applicant: IHI Marine United Inc.
Tokyo 108-0022 (JP)

(72) Inventors:
• AWASHIMA, Yuji
Tokyo 108-0022 (JP)
• YOSHIMOTO, Haruki
Tokyo 108-0022 (JP)

(74) Representative: Köhler, Walter
Louis, Pöhlau, Lohrentz
Patentanwälte
P.O. Box 30 55
90014 Nürnberg (DE)

(54) **THERMOELECTRIC POWER GENERATOR AND POWER GENERATING SYSTEM USING THERMOELECTRIC POWER GENERATOR**

(57)     A thermoelectric power generating device and a power generating system using the same are provided which have easiness in maintenance and require a smaller space and which can perform thermoelectric conversion (power generation) from fluids with different temperatures to conduct electric power supply in a way cheaper and more stable than in the conventional devices.

A thermoelectric element 27 constituted by P- and N-type thermoelectric semiconductor elements arranged alternately and sealed in heat transfer plates 30 in a sandwiched manner through electrodes and insulators to provide a plate-like thermoelectric power generating unit 31. A plurality of the units 31 are laminated to alternately form first and second spaces 32 and 33 for communication of high- and low-temperature fluids W and C, respectively, between the units. Openings provided by the respective units 31 are gathered to form first inflow and outflow passages 34 and 35 for inflow and outflow of the high-temperature fluid W to and out of the first spaces 32, respectively, and second inflow and outflow passages for inflow and outflow of the low-temperature fluid C to and out of the second spaces 33, respectively.

FIG. 4

**Description**

Technical Field

The present invention relates to a thermoelectric power generating device and a power generating system using said thermoelectric power generating device.

Background Art

A power generating system using temperature difference between warm and cold seawaters at ocean surface and in deep sea, respectively, has heretofore been attracting attention as technique utilizing natural energy.

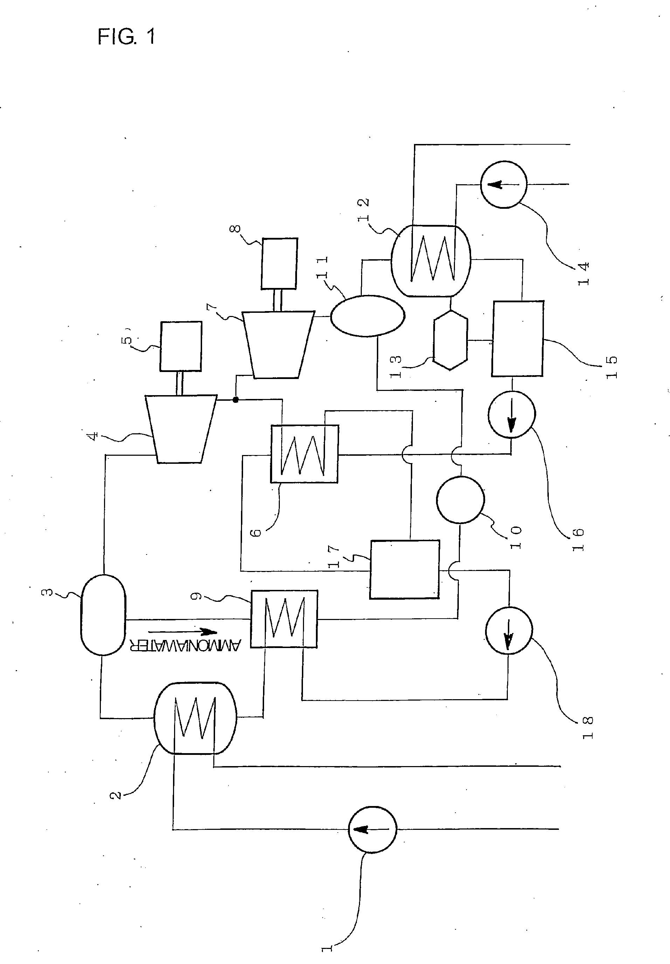

This kind of ocean-thermal energy conversion power generating system comprises, as shown in Fig. 1, a warm seawater pump 1 for pumping warm seawater at an ocean surface, an evaporator 2 for evaporating a mixed liquid of ammonia/water by heat of the warm seawater pumped up by the pump 1, a gas-liquid separator 3 for separating the mixed liquid of ammonia/water evaporated by the evaporator 2 into ammonia water and ammonia/water steams, a first turbine 4 into which the ammonia/water steam separated by the separator 3 is guided, a first power generator 5 rotatively driven by the turbine 4, a heater 6 into which part of the ammonia/water steam from the turbine 4 is extracted and guided, a second turbine 7 into which the remainder of the ammonia/water steam from the turbine 4 is guided, a second power generator 8 rotatively driven by the turbine 7, a regenerator 9 for cooling the ammonia water separated by the separator 3, a decompression valve 10 for decompressing the ammonia water cooled by the regenerator 9, an absorber 11 for absorbing mixed steam discharged from the turbine 7 by the ammonia water decompressed by the valve 10, a condenser 12 for cooling the mixed steam not absorbed by the absorber 11, an aftercondenser 13 for completely condensing, through cooling, the mixed steam not condensed by the condenser 12, a cold seawater pump 14 for pumping up the cold seawater from deep sea, a first tank 15 for storing the ammonia water condensed by the condenser 12 and aftercondenser 13, a first working fluid pump 16 for pumping the ammonia water stored in the tank 15 into the heater 6, a second tank 17 for storing the mixed liquid of ammonia/water pumped by the pump 16 and heated by the heater 6 and a second working fluid pump 18 for pumping the mixed liquid of ammonia/water stored in the tank 17 into the regenerator 9.

In the ocean-thermal energy conversion power generating system, the mixed liquid of ammonia/water stored in the tank 17 is fed by the pump 18 via the regenerator 9 into the evaporator 2; and the warm seawater at the ocean surface is fed by the pump 1 into the evaporator 2. The mixed liquid of ammonia/water is evaporated in the evaporator 2 into gas-liquid mixed phase of ammonia/water which is separated in the separator 3 into ammonia water and ammonia/water steam, the latter being guided into the turbine 4 for rotative drive thereof, whereby power is generated by the power generator 5. The mixed steam discharged from the turbine 4 is partly extracted into the heater 6 and the reminder is guided into the turbine 7 so that the power generator 8 is rotatively driven for power generation.

The ammonia water separated by the gas-liquid separator 3 is cooled in the regenerator 9 by the mixed liquid of ammonia/water and then enters through the decompression valve 10 into the absorber 11 where it absorbs the mixed steam discharged from the turbine 7, the mixed steam not absorbed there entering into the condenser 12 where it is cooled and condensed back into liquid by the cold seawater pumped up by the pump 14 from deep sea and is stored in the tank 15. The liquid stored is pumped by the pump 16 into the heater 6 where it is heated by part of the ammonia/water steam discharged and extracted from the turbine 4 and is stored in the tank 17. The mixed liquid of ammonia/water stored in the tank 17 is pumped again by the pump 18 via the regenerator 9 into the evaporator 2. This operation is repeated for continued power generation only by the seawater.

General state-of-the-art technology for an ocean-thermal energy conversion power generating system as shown in Fig. 1 is disclosed, for example, in Patent Literature 1.

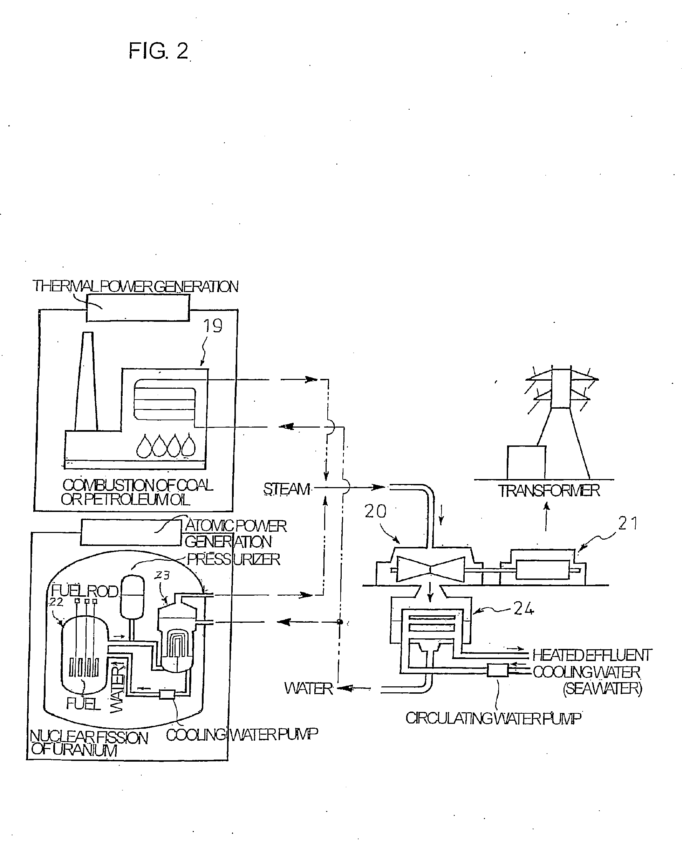

Meanwhile, as shown in Fig. 2, in a thermal power generating plant where fuel such as coal or petroleum oil is burned in a boiler 19 to generate steam by which a steam turbine 20 is rotatively driven for power generation in a power generator 21, or in an atomic power generating plant where fission energy in an uranium reactor pressure vessel 22 is utilized to generate steam in a steam generator 23 by which the steam turbine 20 is rotatively driven for power generation in the power generator 21, the steam having rotatively driven the steam turbine 20 is cooled in a condenser 24 by seawater as cooling water, the condensed water bei.ng circulated.

[Patent Literature 1] JP 5-340342A

Summary of Invention

Technical Problems

However, the ocean-thermal energy conversion power generating system as shown in Fig. 1 is totally much complex in structure because of required instruments such as evaporator 2, first turbine 4, first power generator 5, heater 6, second turbine 7, second power generator 8, regenerator 9, condenser 12 and first and second working fluid pumps 16 and 18, inevitably resulting in increase in cost. Further, periodical maintenances are indispensable since there are many rotary parts. After all, the system comes hardly into practical use under existing conditions.

In the power generating plant as shown in Fig. 2, a grand-scale equipment would be required for recovery of thermal energy. Under existing conditions, the seawater as cooling water, which have been elevated in temperature by drawing heat from the steam in the condenser 24, is discharged to the sea substantially with no recovery of thermal energy.

Thus, it has been desired to develop a device which can effectively recover ocean-thermal energy in an ocean-thermal energy conversion power generating system or in a power generating plant as mentioned in the above.

The invention was made in view of the above and has its object to provide a thermoelectric power generating device and a power generating system using said thermoelectric power generating device which can conduct effective thermoelectric conversion (power generation), using fluids with different temperatures, which is easy in maintenance, which requires smaller space and which can conduct power supply in a way cheaper and more stable than in the conventional devices.

Solution to Problems

The invention is directed to a thermoelectric power generating device comprising a thermoelectric element constituted by P- and N-type thermoelectric semiconductor elements arranged alternately and sealed in heat transfer plates in a sandwich manner through electrodes and insulators to thereby provide a plate-like power generating unit,
a plurality of said plate-like power generating units being laminated to alternately form first and second spaces for communication of high- and low-temperature fluids, respectively, between and partitioned by the respective plate-like power generating units so as not to cause mixing of the high- and low-temperature fluids,
openings provided by the respective plate-like power generating units being gathered to form first inflow and outflow passages for inflow and outflow of the high-temperature fluid to and out of the first spaces, respectively, and second inflow and outflow passages for inflow and outflow of the low-temperature fluid to and out of the second spaces.

The above-mentioned means will provide features and advantages as mentioned in the below.

When the high-temperature fluid is caused to flow via the first inflow passage into the first spaces and drain through the first outflow passage while the low-temperature fluid is caused to flow via the second inflow passage into the second spaces and drain through the second outflow passage, the thermoelectric element constituted by the P- and N-type thermoelectric semiconductor elements arranged alternately and sealed in the heat transfer plates of the plate-like power generating unit brings about conversion of thermal energy into electric energy for generation of electromotive force owing to temperature difference between the high- and low-temperature fluids, so that power is generated effectively.

A power generating system may be constituted by use of the thermoelectric power generating device such that warm seawater at ocean surface is guided as said high-temperature fluid into the first spaces while cold seawater in deep sea is guided as said low-temperature fluid into the second spaces. According to this, unlike conventional ocean-thermal energy conversion power generating systems, no instruments are required such as evaporator, first turbine, first power generator, heater, second turbine, second power generator, regenerator, condenser and first and second working fluid pumps at all, which substantially simplifies the whole structure, averts increase in cost and brings about easiness in maintenance because of no moving parts. As a result, an ocean-thermal energy conversion power generating system can be put into practical use.

Alternatively, .a power generating system may be constituted by use of the thermoelectric power generating device such that stream having driven the steam turbine for power generation is guided as said high-temperature fluid into the first spaces while seawater as said low-temperature fluid is guided into the second spaces. According to this, thermal energy can be effectively withdrawn for power generation unlike conventional power generating plants where the seawater as cooling water elevated in temperature by drawing heat from the steam in the condenser is disposed into the sea as it is.

Alternatively, a power generating system may be constituted by use of the thermoelectric power generating device such that steam or hot water discharged as said high-temperature fluid from various plants is guided into the first spaces while seawater as said low-temperature fluid is guided into second spaces. This makes it possible to effectively withdraw thermal energy in the various plants so as to conduct power generation.

Advantageous Effects of Invention

According to the thermoelectric power generating device of the invention, it is possible to obtain beneficial effects of capability of effective thermoelectric conversion (power generation) by the fluids with different temperatures, easiness in maintenance, requirement of smaller space and capability of electric power supply in a way cheaper and more stable than in the conventional devices.

When a power generating system is constituted by used of the thermoelectric power generating device of the invention such that warm seawater at ocean surface is guided as the high-temperature fluid into the first spaces while cold seawater in deep sea is guided as the low-temperature fluid into the second spaces, it is possible to obtain beneficial effects of simplification in whole structure, prevention of increase in cost and easiness in maintenance because of no moving parts, which can contribute to practical use of an ocean-thermal energy conversion power generating system.

Alternatively, when a power generation system is constituted by use of the thermoelectric power generating device of the invention such that steam having driven the steam turbine for power generation is guided as the high-temperature fluid into the first spaces while seawater is guided as the low-temperature fluid into the second spaces, it is possible to obtain beneficial effects of effectively withdrawing thermal energy, which has been disposed to the hitherto, for power generation and avoiding waste.

Alternatively, when a power generation system is constituted by use of the thermoelectric power generating device of the invention such that steam or hot water discharged from various plants is guided as the high-temperature fluid into the first spaces while seawater is guided as the low-temperature fluid into the second spaces, it is possible to obtain beneficial effects of effectively withdrawing thermal energy in the various plants for power generation and avoiding waste.

Brief Description of Drawings

Fig. 1 is a block diagram showing a conventional ocean-thermal energy conversion power generating system;
Fig. 2 is a schematic diagram showing a conventional power generating plant;
Fig. 3 is a perspective view showing a thermoelectric power generating device according to an embodiment of the invention;
Fig. 4 is a sectional view showing the thermoelectric power generating device according to the embodiment of the invention and corresponding to a view looking in the direction of arrows IV in Fig. 3;
Fig. 5 is a sectional view showing the thermoelectric power generating device according to the embodiment of the invention and corresponding to a view looking in the direction of arrows V in Fig. 3;
Fig. 6 is a sectional view showing substantial portions in the thermoelectric power generating device according to the embodiment of the invention and corresponding to a view showing part VI in Fig. 4;
Fig. 7 is a schematic view showing first space and flow of high-temperature fluid in the thermoelectric power generating device according to the embodiment of the invention and corresponding to a view looking in the direction of arrows VII in Figs. 4 and 5;
Fig. 8 is a schematic view showing second space and flow of low-temperature fluid in the thermoelectric power generating device according to the embodiment of the invention and corresponding to a view looking in the direction of arrows VIII in Figs. 4 and 5;
Fig. 9 is a schematic view showing application of the thermoelectric power generating device according to the embodiment of the invention to an ocean-thermal energy conversion power generating system; and
Fig. 10 is a schematic view showing application of the thermoelectric power generating device according to the embodiment of the invention to a power generating plant.

Reference Signs List

20 steam turbine
25 P-type thermoelectric semiconductor element
26 N-type thermoelectric semiconductor element
27 thermoelectric element
28 electrode
29 insulator
30 heat transfer plate
31 plate-like thermoelectric power generating unit
32 first space
33 second space
34 first inflow passage
35 first outflow passage
36 second inflow passage
37 second outflow passage

38    thermoelectric power generating device
39    motor
40    warm seawater pump
41    motor
42    cold seawater pump
43    motor
44    seawater pump
W     high-temperature fluid
C     low-temperature fluid

Description of Embodiment

An embodiment of the invention will be described in conjunction with the drawings.

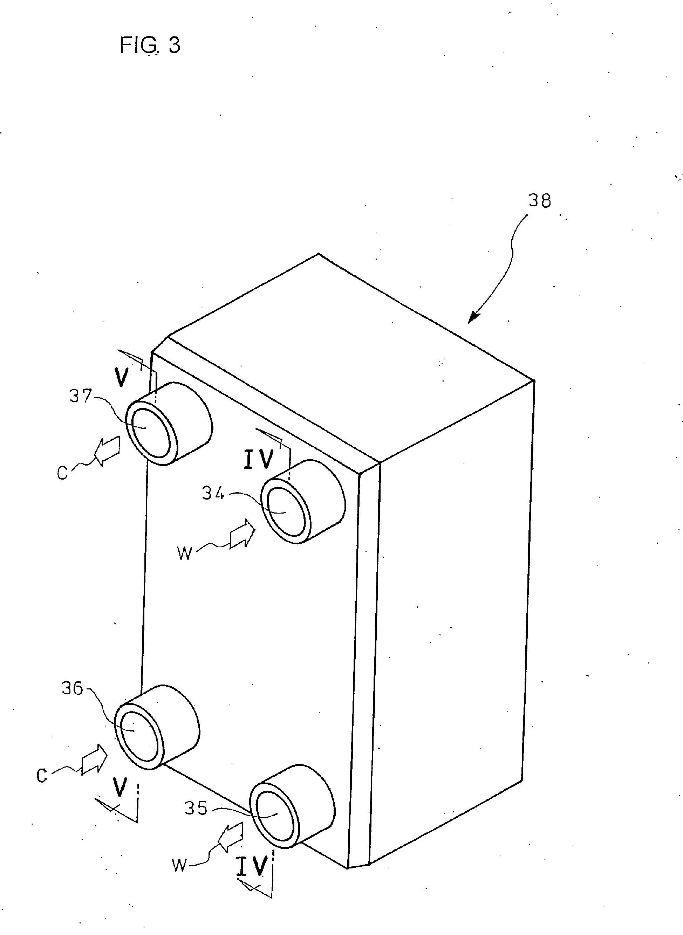

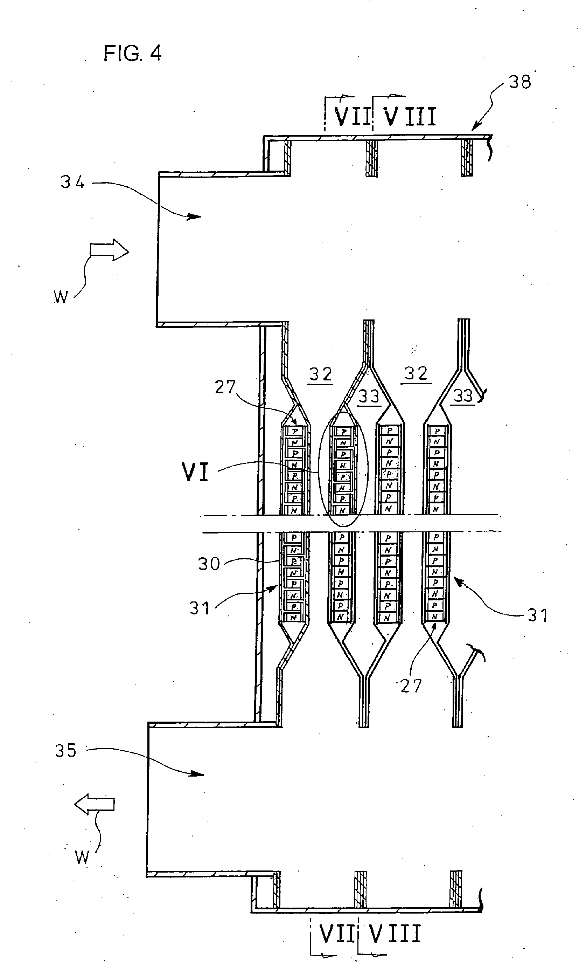

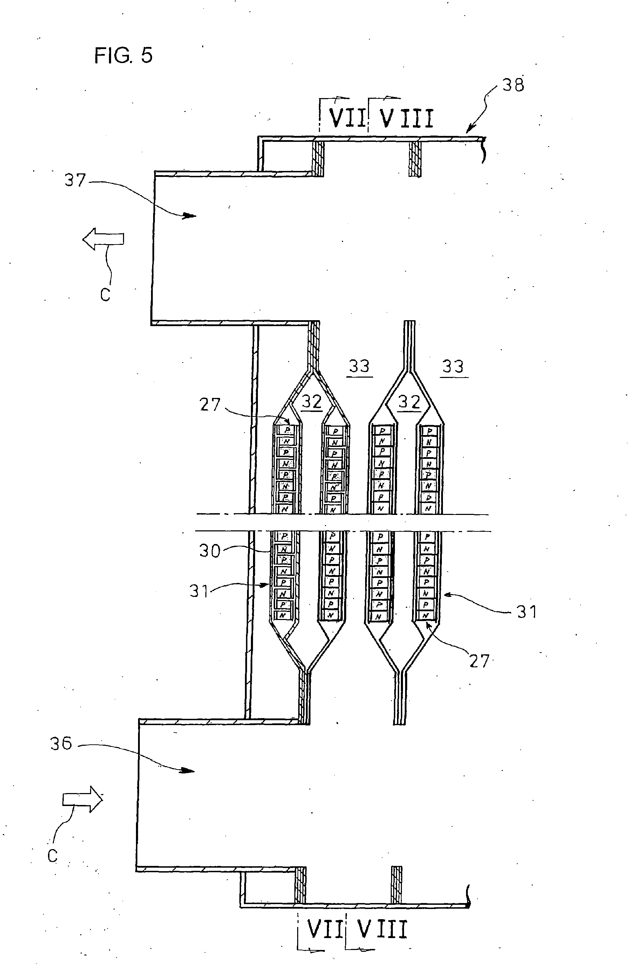

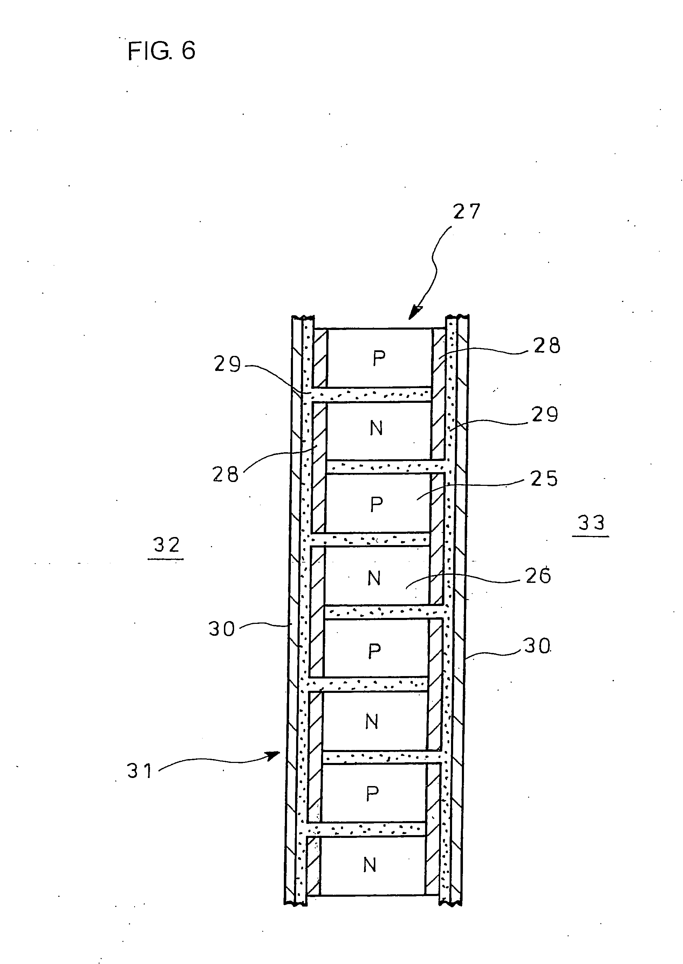

Figs. 3-8 show the embodiment in which a thermoelectric element 27 constituted by P- and N-type thermoelectric semiconductor elements 25 and 26 arranged alternately and sealed in heat transfer plates 30 in a sandwiched manner through electrodes 28 and insulators 29 to thereby provide a plate-like thermoelectric power generating unit 31, a plurality of such plate-like thermoelectric power generating units 31 being laminated to alternately form first and second spaces 32 and 33 for communication of high- and low-temperature fluids W and C, respectively, between and partitioned by the respective plate-like thermoelectric power generating units 31 so as not to cause mixing of the high- and low-temperature fluids W and C, openings provided by the respective plate-like thermoelectric power generating units 31 being gathered to form first inflow and outflow passages 34 and 35 for inflow and outflow of the high-temperature fluid W to and out of the first spaces 32, respectively, and second inflow and outflow passages 36 and 37 for inflow and outflow of the low-temperature fluid C to and out of the second spaces 33, respectively, thereby providing a thermoelectric power generating device 38.

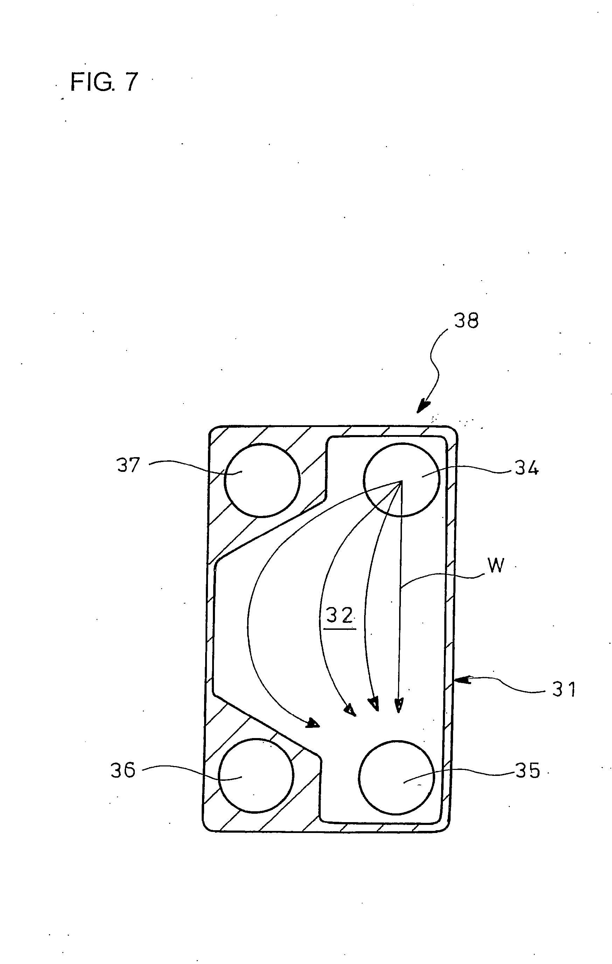

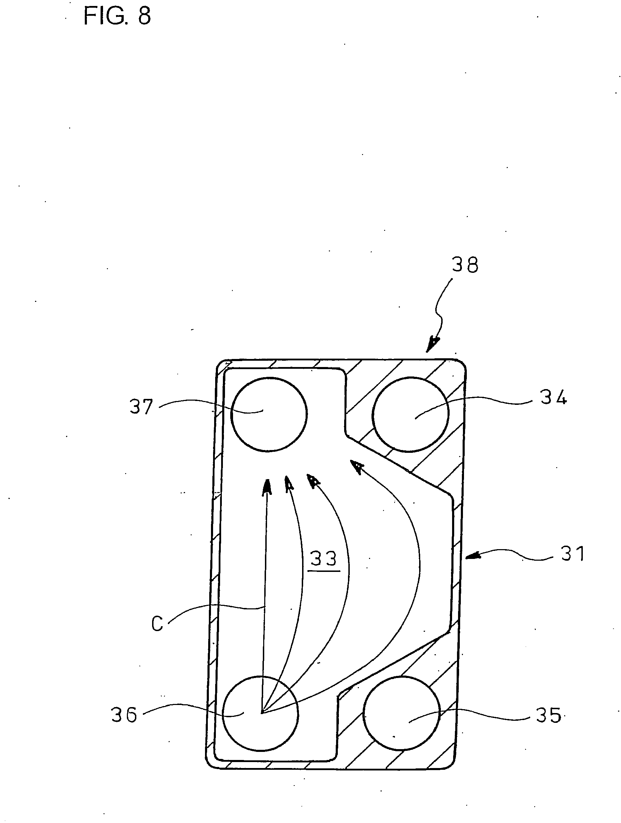

In the embodiment, the first inflow and outflow passages 34 and 35 are formed at right upper and lower corners of the respective plate-like thermoelectric power generating units 31 in Fig. 7, respectively; the high-temperature fluid W from the first inflow passage 34 flows substantially trapezoidally from top to bottom in each of the first spaces 32 into the first outflow passage 35. The second inflow and outflow passages 36 and 37 are formed at left lower and upper corners of the respective plate-like thermoelectric power generating units 31 in Fig. 8, respectively; the low-temperature fluid C from the second inflow passage 36 flows substantially trapezoidally from bottom to top in each of the second spaces 33 into the second outflow passage 37. However, of course, the positions of the inflow and outflow passages 34, 35, 36 and 37 and the direction of flows of the high- and low-temperature fluids W and C are not restricted to those in the embodiment shown in Figs. 7 and 8 and may be selected depending upon circumstances.

Performance of the thermoelectric element 27 using the P- and N-type thermoelectric semiconductor elements 25 and 26 depends on thermoelectric figure-of-merit Z [K$^{-1}$].

$$Z = \alpha^2 \cdot \sigma / \lambda$$

where

$$\alpha: \text{ Seebeck coefficient } [V/K]$$

$$\sigma: \text{ electric conductivity } [S/m]$$

$$\lambda: \text{ heat conductivity } [W/mK]$$

Thus, selection of material with greater Seebeck coefficient $\alpha$ and greater electric conductivity $\sigma$ and less heat conductivity $\lambda$ becomes effective; use of for example, Bi-Te (bismuth-tellurium) material becomes effective for the P- and N-type thermoelectric semiconductor elements 25 and 26.

Next, mode of operation of the above embodiment will be described.

In the thermoelectric power generating device 38, the high-temperature fluid is caused to flow via the first inflow passage 34 into the first spaces 32 and drain through the first outflow passage 35 while the low-temperature fluid C is caused to flow via the second inflow passage 36 into the second spaces 33 and drain through the second outflow passage 37. As a result, in the thermoelectric element 27 constituted by the P- and N-type thermoelectric semiconductor elements 25 and 26 arranged alternately and sealed in the heat transfer plates 30 of the plate-like thermoelectric power generating unit 31, thermal energy is converted into electric energy for generation of electromotive force owing to temperature difference between the high- and low-temperature fluids W and C, so that power is generated effectively.

The electric power generated in the plate-like thermoelectric power generating units 31 of the thermoelectric power generating device 38 is taken out from terminals (not shown) connected to the electrodes 28.

The plate-like thermoelectric power generating units 31 in the thermoelectric power generating device 38, which may be dismantled for complete cleanup, has easiness in maintenance. Moreover, electric capacity may be controlled by increasing/decreasing in number the plate-like thermoelectric power generating units 31.

Thus, thermoelectric conversion (power generation) can be effectively conducted by fluids with different temperatures to conduct electric power supply with easiness in maintenance and with requirement in smaller space and in a way cheaper and more stable than in the conventional devices.

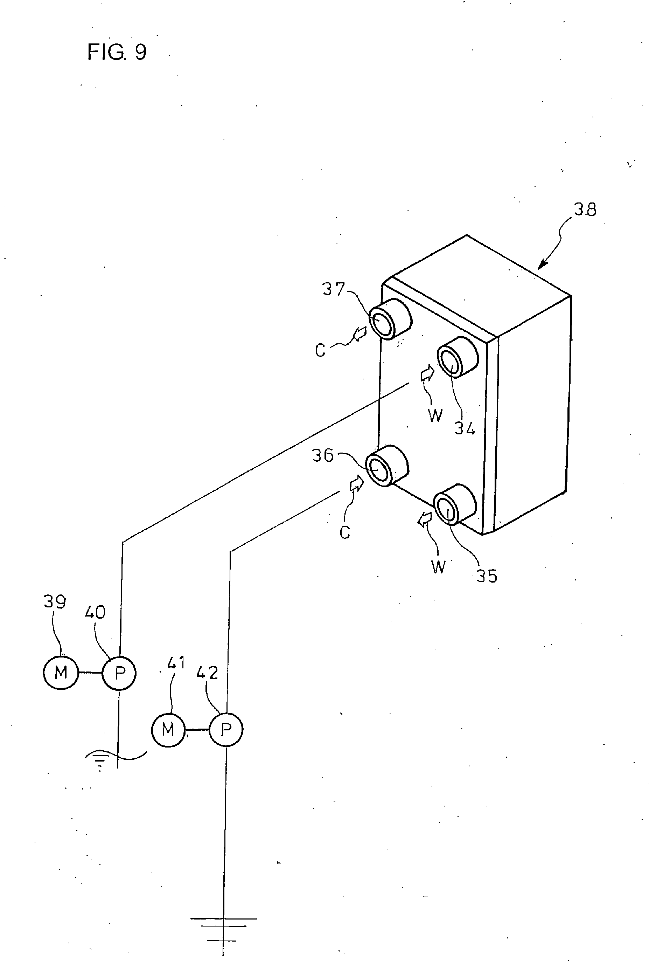

Fig. 9 is a schematic view showing application of the thermoelectric power generating device according to the embodiment of the invention to an ocean-thermal energy conversion power generating system in which parts similar to those in Figs. 3-8 are represented by the same reference numerals. The warm seawater at ocean surface as high-temperature fluid W is guided via the first inflow passage 34 of the thermoelectric power generating device 38 into the first spaces 32 by a warm seawater pump 40 driven by a motor 39 while the cold sea water in deep sea as low-temperature fluid C is guided via the second inflow passage 36 of the thermoelectric power generating device 38 into the second spaces 33 by a cold seawater pump 42 driven by a motor 41, thereby providing a power generating system.

When constructed as shown in Fig. 9, unlike the conventional ocean-thermal energy conversion power generating system as shown in Fig. 1, no instruments are required such as evaporator 2, first turbine 4, first power generator 5, heater 6, second turbine 7, second power generator 8, regenerator 9, condenser 12 and first and second working fluid pumps 16 and 18 at all, which substantially simplifies the whole structure, averts increase in cost and brings about easiness in maintenance because of no moving parts. As a result, an ocean-thermal energy conversion power generating system can be put into practical use.

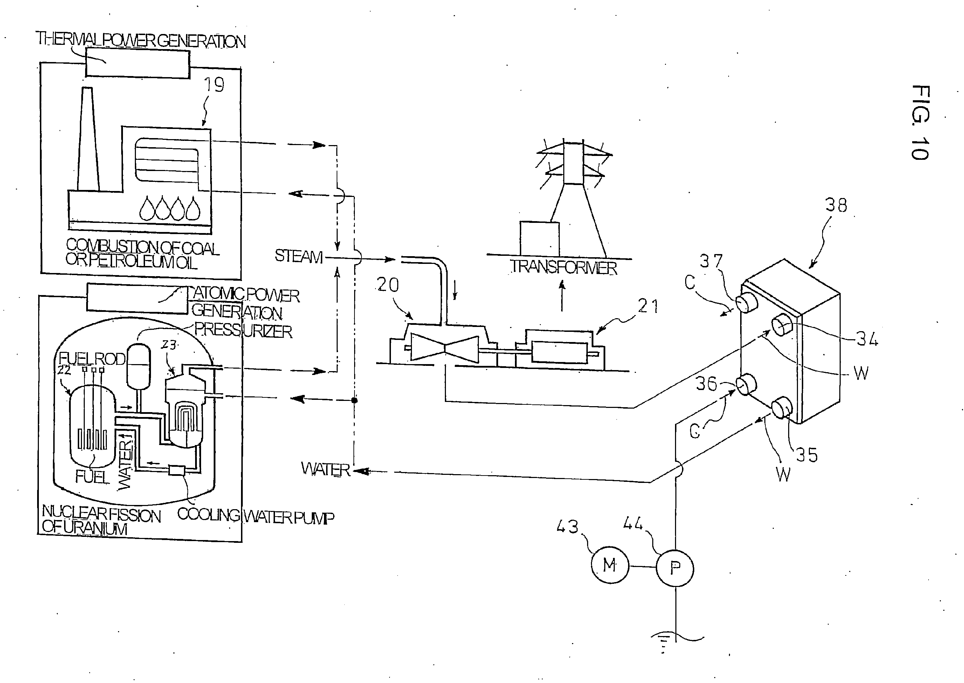

Fig. 10 is a schematic view showing application of the thermoelectric power generating device according to the embodiment of the invention to a power generating plant in which parts similar to those in Figs. 3-8 are represented by the same reference numerals. The steam as high-temperature fluid W having driven the steam turbine 20 for power generation is guided via the first inflow passage 34 of the thermoelectric power generating device 38 into the first spaces 32 while the seawater as low-temperature fluid C is guided via the second inflow passage 36 of the thermoelectric power generating device 38 into the second spaces 33 by a seawater pump 44 driven by a motor 43, thereby providing a power generating system.

When constructed as shown in Fig. 10, thermal energy can be effectively withdrawn for power generation unlike the conventional power generating plant as shown in Fig. 2 where the seawater as cooling water elevated in temperature by drawing heat from the steam in the condenser 24 is disposed into the sea as it is.

Alternately, a power generating system may be constituted by used of the thermoelectric power generating device 38 such that steam or hot water discharged from various plants (not shown) is guided as high-temperature fluid W via the first inflow passage 34 into the first spaces 32 while seawater is guided as low-temperature fluid C via the second inflow passage 36 into the second spaces 33. This makes it possible to effectively withdraw thermal energy in the various plants so as to conduct power generation.

It is to be understood that a thermoelectric power generating device and a power generating system using said thermoelectric power generating device according to the invention are not limited to the above-mentioned embodiment and that various changes and modifications may be made without departing from the scope of the invention.

**Claims**

1. A thermoelectric power generating device comprising a thermoelectric element constituted by P- and N-type thermoelectric semiconductor elements arranged alternately and sealed in heat transfer plates in a sandwiched manner through electrodes and insulators to thereby provide a plate-like thermoelectric power generating unit, a plurality of said plate-like thermoelectric power generating units being laminated to alternately form first and second spaces for communication of high- and low-temperature fluids, respectively, between and partitioned by the respective plate-like thermoelectric power generating units so as not to cause mixing of the high-and low-temperature fluids, openings provided by the respective plate-like thermoelectric power generating units being gathered to form first inflow and outflow passages for inflow and outflow of the high-temperature fluid to and out of the first spaces, respectively, and second inflow and outflow passages for inflow and outflow of the low-temperature fluid to and out of the second spaces, respectively.

2. A power generating system using a thermoelectric power generating device as claimed in claim 1 wherein warm seawater at ocean surface is guided as said high-temperature fluid into the first spaces while cold seawater in deep sea is guided as said low-temperature fluid into the second spaces.

3. A power generating system using a thermoelectric power generating device as claimed in claim 1 wherein steam having driven the steam turbine for power generation is guided as said high-temperature fluid into the first spaces while seawater is guided as said low-temperature fluid into the second spaces.

4. A power generating system using a thermoelectric power generating device as claimed in claim 1 wherein steam or hot water discharged from various plants is guided as said high-temperature fluid into the first spaces while seawater is guided as said low-temperature fluid into the second spaces.

FIG. 1

# FIG. 2

THERMAL POWER GENERATION

19

COMBUSTION OF COAL OR PETROLEUM OIL

ATOMIC POWER GENERATION
PRESSURIZER

FUEL ROD
22    23
WATER
FUEL

NUCLEAR FISSION OF URANIUM

COOLING WATER PUMP

STEAM

WATER

20

TRANSFORMER

21

24

HEATED EFFLUENT
COOLING WATER (SEAWATER)

CIRCULATING WATER PUMP

FIG. 3

FIG. 4

FIG. 5

FIG. 6

FIG. 7

FIG. 8

FIG. 9

FIG. 10

THERMAL POWER GENERATION

COMBUSTION OF COAL OR PETROLEUM OIL

ATOMIC POWER GENERATION

PRESSURIZER

FUEL ROD

FUEL

WATER

NUCLEAR FISSION OF URANIUM

COOLING WATER PUMP

STEAM

WATER

TRANSFORMER

## INTERNATIONAL SEARCH REPORT

| International application No. |
| --- |
| PCT/JP2008/002627 |

A. CLASSIFICATION OF SUBJECT MATTER
*H02N11/00(2006.01)i*

According to International Patent Classification (IPC) or to both national classification and IPC

B. FIELDS SEARCHED

Minimum documentation searched (classification system followed by classification symbols)
H02N11/00

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | Microfilm of the specification and drawings annexed to the request of Japanese Utility Model Application No. 060834/1985(Laid-open No. 175845/1986) (Osaka Gas Co., Ltd., Harman Co., Ltd.), 01 November, 1986 (01.11.86), Description, page 3, line 17 to page 4, line 16; Figs. 1 to 3 (Family: none) | 1-4 |
| Y | JP 2005-260155 A (Central Research Institute of Electric Power Industry), 22 September, 2005 (22.09.05), Par. Nos. [0033] to [0035], [0045], [0046]; Figs. 1, 4 to 6 (Family: none) | 1-4 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 18 December, 2008 (18.12.08) | 06 January, 2009 (06.01.09) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2008/002627 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 05-340342 A  (Toshiba Corp.),<br>21 December, 1993 (21.12.93),<br>Par. No. [0002]<br>(Family: none) | 2-4 |
| Y | JP 02-238104 A  (Mitsubishi Heavy Industries,<br>Ltd.),<br>20 September, 1990 (20.09.90),<br>Claims; Figs. 1, 3 to 6<br>(Family: none) | 3 |
| Y | JP 2006-271163 A  (Toshiba Corp.),<br>05 October, 2006 (05.10.06),<br>Par. No. [0024]; Fig. 1<br>(Family: none) | 4 |

Form PCT/ISA/210 (continuation of second sheet) (April 2007)

**EP 2 197 098 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5340342 A